# FASCICULE DE BREVET EUROPEEN

(11) **EP 1 986 239 B1**
(45) Date de publication et mention de la délivrance du brevet: **14.03.2012**
(21) Numéro de dépôt: 08300187.5
(22) Date de dépôt: 21.04.2008
(51) Int. Cl.: H01L 27/146, H01L 21/60, H01L 29/06, H01L 25/18, H01L 23/544

(54) **Procédé pour la réalisation d'une matrice de détection de rayonnements électromagnétiques et notamment de rayonnements infrarouges.**
Verfahren zur Herstellung einer Matrix zur Detektion elektromagnetischer Strahlung insbesondere Infrarotstrahlung
Method for making a matrix for detecting electromagnetic radiation and, in particular, infrared radiation.

(30) Priorité: 25.04.2007 FR 0754677
(43) Date de publication de la demande: 29.10.2008
(73) Titulaire: Société Française de Détecteurs Infrarouges - SOFRADIR, 92290 Châtenay Malabry (FR)
(72) Inventeur: Pitault, Bernard, 38960 Saint Etienne de Crossey (FR)
(74) Mandataire: Vuillermoz, Bruno

(56) Documents cités:
- FR-A- 2 857 504
- US-A- 5 270 255
- US-A1- 2004 104 488

## Description

### DOMAINE DE L'INVENTION

La présente invention concerne un procédé de réalisation d'une matrice de détection de rayonnements électromagnétiques. Elle concerne plus particulièrement la réalisation de détecteurs de rayonnements infrarouges.

Plus particulièrement, elle vise la réalisation de telles matrices présentant un plan focal relativement important et typiquement supérieur à 100 mm.

### ETAT ANTERIEUR DE LA TECHNIQUE

Des capteurs d'image de grande dimension ont été décrit dans le document FR 2 857 504.

Les détecteurs de rayonnements électromagnétiques sont classiquement constitués d'un circuit de détection desdites ondes à détecter, et donc sensibles à la gamme de longueurs d'onde correspondante, transformant de manière connue un rayonnement électromagnétique en un signal électrique. Ce circuit de détection est associé à un circuit électronique de lecture, destiné à transformer les signaux électriques issus du circuit de détection pour les rendre susceptibles de subir un traitement ultérieur, notamment après amplification.

De manière connue également, la liaison tant mécanique qu'électrique intervenant entre le circuit de détection et le circuit de lecture s'effectue par la technologie dite d'hybridation par billes ou microbilles, également dénommée sous l'expression anglo-saxonne «*flip chip*». Ces billes ou microbilles sont réalisées en indium, voire en alliage étain/plomb.

Le circuit de détection est traditionnellement composé d'un matériau transparent ou peu absorbant du rayonnement à détecter, et est par exemple constitué de CdTe, CdZnTe, voire de germanium, sur lequel est déposé par épitaxie (en phase liquide, en phase vapeur, voire par jet moléculaire) une couche mince absorbante de HgCdTe constituant le circuit de détection proprement dit.

Le circuit de lecture est le plus souvent réalisé en silicium.

Ces différentes technologies sont aujourd'hui bien maîtrisées.

Cependant, les évolutions observées dans le domaine de la détection, et plus particulièrement dans le domaine spatial, nécessitent de faire appel à des plans focaux de très grandes dimensions, typiquement supérieures à 100 mm. Ceci impose, s'agissant de l'élément de détection proprement dit, la mise en oeuvre de plusieurs modules élémentaires de détection aboutés l'un à l'autre ou disposés en quinconce. Or, de tels systèmes de détection ont un certain nombre d'exigences liées notamment à la focalisation, à la reconstitution d'une barrette de détection de très grandes dimensions..., qui imposent dès lors des contraintes sur les positionnements relatifs des divers modules élémentaires, d'une part dans les deux dimensions du plan dans lequel ils sont inscrits (cotes X, Y), et d'autre part sur la dispersion selon la cote Z, c'est-à-dire selon la direction perpendiculaire au plan des diverses diodes constituant le plan focal.

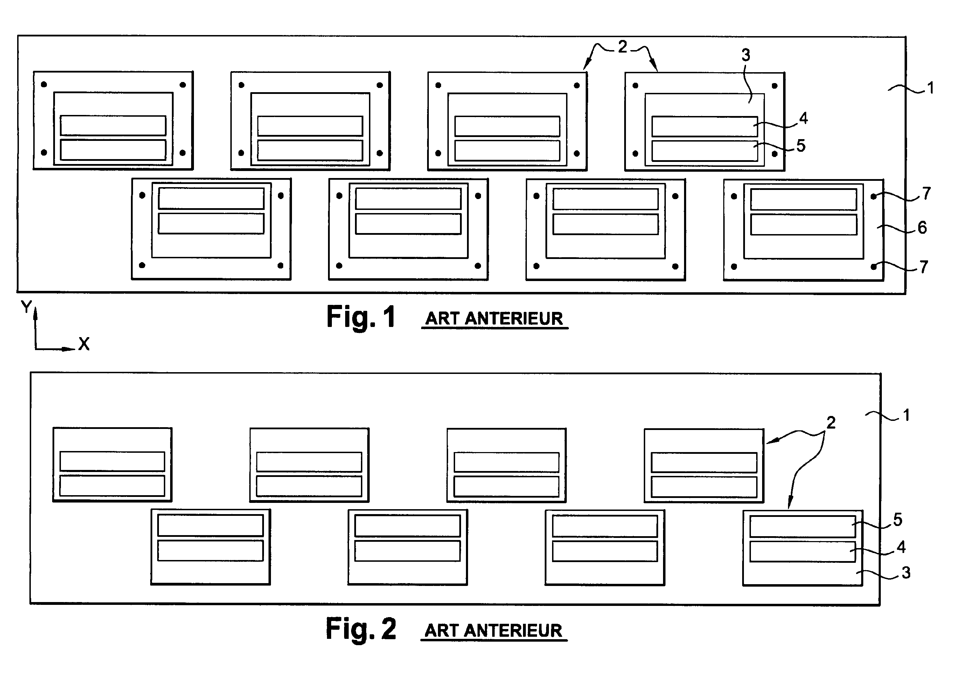

Parmi les solutions techniques proposées à ce jour, on a tout d'abord proposé la fixation mécanique des différents modules élémentaires constitutifs du plan focal par vissage ou clampage sur le réseau ou substrat d'interconnexion. On a représenté en relation avec la figure 1, une illustration de cette technologie. On a ainsi représenté par la référence **1** le substrat d'interconnexion et par la référence **2** les différents modules élémentaires montés en quinconce, propres à constituer la barrette de détection.

Chacun de ces modules **2** comporte un circuit de lecture **3,** et dans l'exemple décrit deux circuits de détection **4, 5** correspondant à deux gammes de longueurs d'onde différentes. Chacun de ces modules **2** est collé sur une semelle de report **6,** typiquement réalisée en molybdène, le vissage ou le clampage **7** ne pouvant s'effectuer directement sur le circuit de lecture.

Le collage du module élémentaire **2** sur la semelle de report **6** induit de fait une dispersion selon la cote Z dans la position des divers photosites, affectant dès lors la précision selon ladite cote, et affectant la qualité de détection finale. De plus, ce mode de réalisation nécessite l'utilisation d'outillage de report extrêmement précis pour le positionnement, sur le substrat d'interconnexion, des ensembles constitués de modules élémentaires collés sur semelles et notamment la mise en oeuvre de mires d'alignement complexes à mettre en oeuvre.

Surabondamment, en raison des différents cyclages thermiques auxquels sont confrontés de tels détecteurs, étant rappelé que ceux-ci sont destinés à fonctionner à basses températures notamment comprises entre 50 K et 200K avec de multiples remontées à la température ambiante (20°C) voire plus (80°C) dans le cas de recuits de décontamination. La liaison rigide créée entre le circuit de lecture et la semelle de report, matériaux dont les coefficients moyens de dilatation thermiques diffèrent quelque peu sur la plage de température, conduit à la formation d'un bilame se traduisant par des contraintes en traction/compression/cisaillement sur les billes d'indium, contraintes pouvant conduire à des ruptures de connexion en particulier sur les billes extrêmes. De plus, le positionnement par clampage mécanique réalisé à température ambiante peut évoluer lors de la descente en froid et conduire à des évolutions de positionnement selon les axes X et Y.

On a également proposé (voir figure 2) un maintien mécanique des différents modules élémentaires par collage. Selon cette technologie, chacun des modules élémentaires **2** est positionné sur le réseau ou substrat d'interconnexion **1,** et son maintien en position est assuré par polymérisation d'un lit de colle déposé entre le circuit de lecture **3** et ledit substrat d'interconnexion.

Là encore, ce mode de report passe par l'utilisation d'outillage de report extrêmement précis du même type que celui mentionné précédemment. Par ailleurs, on peut observer une évolution du positionnement de chaque module élémentaire durant le cycle de polymérisation de la colle, générant notamment des dispersions selon les axes X et Y. De plus la très difficile maîtrise de l'épaisseur moyenne des différents collages et de leurs homogénéités conduit inévitablement à des dispersions selon l'axe Z.

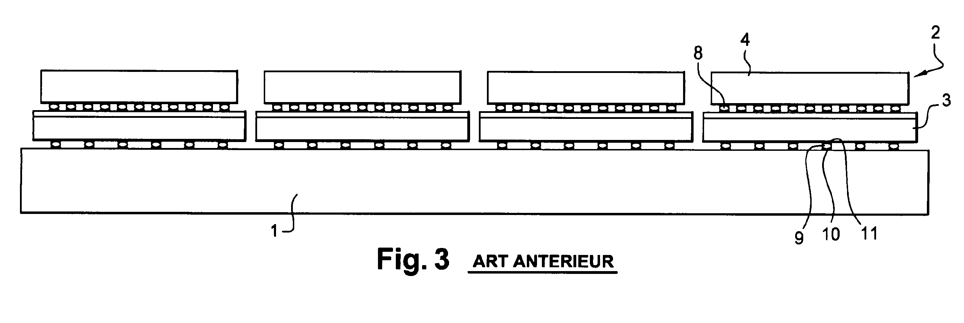

Enfin on a proposé (voir figure 3), un mode de fixation des modules élémentaires **2** sur le substrat d'interconnexion **1** par hybridation, mettant en oeuvre là encore la technologie *« Flip Chip* ». Le maintien en position peut, dans le cas d'espèce, être renforcé par polymérisation d'une colle que l'on aura fait migrer entre le circuit de lecture 3 et le réseau d'interconnexion 1 *(underfilling) -* cela ne peut constituer qu'un renfort éventuel du maintien. Si certes, cette technologie permet d'aboutir à un haut degré de précision, en revanche, elle s'avère d'un coût de réalisation particulièrement élevé dans la mesure où ce mode de report nécessite la réalisation de plots d'accrochage métalliques **11** sur la face arrière du circuit de lecture **3,** ces plots faisant fonction de surface de mouillage, servent à l'accrochage de la bille d'indium **9** élaborée sur le réseau d'interconnexion, présentant lui aussi des plots d'accrochage **10.** Il s'avère de fait nécessaire de disposer d'un aligneur double face afin d'assurer un parfait alignement des motifs gravés en face avant du réseau d'interconnexion et en face arrière du circuit de lecture.

### EXPOSE DE L'INVENTION

L'invention propose un nouveau procédé permettant tout à la fois d'assurer un positionnement et un maintien précis des différents modules élémentaires sur le substrat au réseau d'interconnexions, sans complexifier outre mesure sa réalisation proprement dite.

Ce procédé pour la réalisation d'une matrice de détection de rayonnements électromagnétiques, et notamment de rayons infrarouges, ladite matrice étant constituée d'une pluralité de modules de détection élémentaires rapportés sur un substrat d'interconnexion, et lesdits modules étant eux-mêmes composés d'au moins un circuit de détection dudit rayonnement, connecté à un circuit de lecture par hybridation, lesdits circuits de lecture étant eux-mêmes solidarisés au substrat d'interconnexion, consiste :
■ à ménager au niveau de la face arrière du circuit de lecture de chacun des modules élémentaires :
   - des sillons ou rainures, destinés à permettre la migration d'une colle apte à assurer la solidarisation desdits modules sur le substrat d'interconnexion,
   - et des zones exemptes de tels sillons ou rainures, afin de permettre un contact direct entre lesdits modules et ledit substrat d'interconnexion ;
■ à rapporter d'une part, sur la face avant du substrat d'interconnexion, et d'autre part sur la face avant du circuit de détection, des motifs d'indexation, aptes à assurer un positionnement précis, notamment selon les cotes X et Y de chacun des modules élémentaires sur ledit substrat d'interconnexion ;
■ à induire le plaquage de chacun des modules sur le substrat d'interconnexion après positionnement desdits modules, les zones exemptes de sillons ou de rainures de la face arrière du circuit de lecture étant alors en contact direct avec le substrat d'interconnexion ;
■ à assurer la migration de la colle dans les sillons ou rainures prévus à cet effet ;
■ à augmenter la température de l'enceinte de réalisation de ladite matrice pour induire la polymérisation de la colle.

En d'autres termes, l'invention consiste d'une part, à mettre en oeuvre les précisions d'indexation en faisant appel à des motifs rapportés en face avant du réseau d'interconnexion et en face avant du circuit de détection notamment, et d'autre part, à assurer un contact direct en l'absence de toute semelle de report ou de colle entre la face arrière du circuit de lecture et le réseau d'interconnexion, le maintien étant néanmoins réalisé par collage par des rainures ou évidements ménagés sur ladite face arrière du circuit de lecture, la précision du positionnement étant conservée pendant l'étape de polymérisation de la colle par maintien du plaquage effectif desdits modules sur le substrat d'interconnexion.

Selon une caractéristique de l'invention, ce plaquage est obtenu par dépression ou aspiration des modules sur le substrat d'interconnexion, ce dernier étant percé de canalisations reliées à une ou plusieurs sources de vide ou d'aspiration, lesdites canalisations débouchant au niveau de la face avant du substrat d'interconnexion à l'aplomb des zones de la face arrière des modules élémentaires exemptes de sillons ou de rainures.

Selon l'invention, la réalisation des modules élémentaires et notamment l'alignement du ou des circuits de détection sur un même circuit de lecture est également réalisé à l'aide de motifs d'indexation respectivement positionnés sur la face avant du circuit de lecture et sur la face arrière du ou des circuit(s) de détection.

De plus et selon une caractéristique de l'invention, l'un au moins des circuits de détection d'un même module élémentaire présente une longueur telle qu'il dépasse de part et d'autre dudit module, afin de permettre la réalisation sur sa face avant d'un motif d'indexation permettant son positionnement précis sur le substrat d'indexation pourvu, comme déjà dit, également de motifs d'indexation.

Selon une variante, on rapporte sur le circuit de lecture un composant, dont la longueur dépasse également de part et d'autre du circuit de lecture, et destiné à simplement recevoir un tel motif d'indexation, ce composant étant hybridé provisoirement sur le circuit de lecture.

### BREVE DESCRIPTION DES DESSINS

La manière dont l'invention peut être réalisée et les avantages qui en découlent ressortiront mieux de des exemples de réalisation qui suivent, donnés à titre indicatif et non limitatif à l'appui des figures annexées.
La figure 1 est une représentation schématique vue du dessus d'une technologie de l'art antérieur mettant en oeuvre le clampage ou vissage mécanique de modules élémentaires sur le substrat d'interconnexion.
La figure 2, également déjà décrite, est une représentation schématique de la technologie de l'art antérieur vue du dessus, mettant en oeuvre la technologie du collage des modules élémentaires sur le substrat d'indexation.
La figure 3 est une vue schématique en section longitudinale d'une autre technologie de l'art antérieur mettant en oeuvre l'hybridation des modules élémentaires sur le substrat d'interconnexion.
La figure 4 est une représentation schématique en section visant à illustrer une première étape de fabrication d'un module élémentaire.
La figure 5 est une vue analogue à la figure 4, représentant une seconde étape de réalisation dudit module.
La figure 6 est une représentation schématique en section illustrant le positionnement des modules élémentaires sur le substrat d'interconnexion conformément à l'invention.
La figure 7 représente l'étape suivante de positionnement et de maintien des modules élémentaires sur le substrat d'interconnexion.
La figure 8 illustre l'étape ultime de réalisation du détecteur conforme à l'invention après retrait de l'outillage.
Les figures 9 et 10 sont des représentations schématiques en vue du dessus d'un module élémentaire selon une première variante de l'invention, respectivement avec un et trois circuits de détection.
Les figures 11 et 12 sont des vues analogue aux figures 9 et 10 d'une seconde variante de l'invention, mettant en oeuvre un composant inactif sur le plan de la détection, hybridé sur le circuit de lecture.
Les figures 13 et 14 sont des vues analogue aux figures 11 et 12 d'une troisième variante de l'invention, mettant également en oeuvre un composant inactif sur le plan de la détection, hybridé sur le circuit de lecture.

### DESCRIPTION DETAILLEE DE L'INVENTION

L'invention est plus est plus particulièrement décrite en relation avec des détecteurs infrarouges. Il est cependant bien entendu que l'invention ne saurait se limiter à cette seule application, et qu'elle est transférable à tous types de rayonnements électromagnétiques, notamment au domaine visible.
Il va tout d'abord être décrit la réalisation des modules élémentaires de détection **2** conformément à la présente invention. Il sera tout d'abord rappelé, ainsi que par ailleurs illustré en relation avec les figures 1 et 2 de l'état antérieur de la technique, qu'il est possible d'hybrider plusieurs circuits de détection **4, 5** sur un même circuit de lecture **3,** en fonction du nombre de gammes de longueurs d'onde que le détecteur final est destiné à détecter.

Ce circuit de détection **4** est par exemple constitué d'une première couche d'un matériau transparent aux rayonnements infrarouges, d'une épaisseur typique comprise entre 200 à 800 micromètres, et par exemple constitué de CdTe ou de CdZnTe. On dépose sur cette première couche par épitaxie par épitaxie par jet moléculaire par exemple, une seconde couche plus mince, en HgCdTe **4',** constituant la couche de détection proprement dite. Celle-ci est donc disposée en face avant du circuit de détection. Il s'agit de dispositifs avec éclairement face arrière

On rapporte sur cette face avant des motifs d'alignement **13,** typiquement constitués de métal (ou métaux) gravé et dont les géométries et positionnements précis sont obtenues par photolithographie. Ces motifs sont générés lors du procédé de fabrication du circuit de détection

Corollairement, le circuit de lecture **3** est constitué d'un empilement de silicium aminci **3'** constituant la face avant du circuit de lecture sur une couche plus épaisse de germanium. La liaison rigide entre ces deux matériaux est assurée soit par de la colle époxy, soit par adhésion moléculaire, et ce de manière connue.

Sont positionnés sur la face avant du circuit de lecture **3',** donc sur la couche de silicium, également des motifs d'indexation **14,** destinés à favoriser lors de l'hybridation le positionnement du circuit de détection sur ledit circuit de lecture lors de la phase d'hybridation subséquente.

Parallèlement et de manière connue, afin de réaliser cette hybridation, des surfaces de mouillabilités sont également implantées respectivement sur la face avant du circuit de détection et sur la face avant du circuit de lecture, à l'aplomb les unes des autres pour favoriser l'accroche des microbilles d'indium **8.**

Afin de favoriser les positionnements précis en X et en Y du circuit de détection sur le circuit de lecture, les motifs d'alignement **13** sont situés à l'aplomb des motifs d'alignement **14** du circuit de lecture.

A cette fin, on met en oeuvre une machine d'hybridation telle que part exemple commercialisée sous la dénomination SUSS MICROTEC FC 150 assurant le dépôt avec une précision d'environ 1,0 µm en X et Y, et l'hybridation simultanée du ou des différents circuit(s) de détection sur le circuit de lecture. On obtient ce faisant un module élémentaire **2** conforme à l'invention.

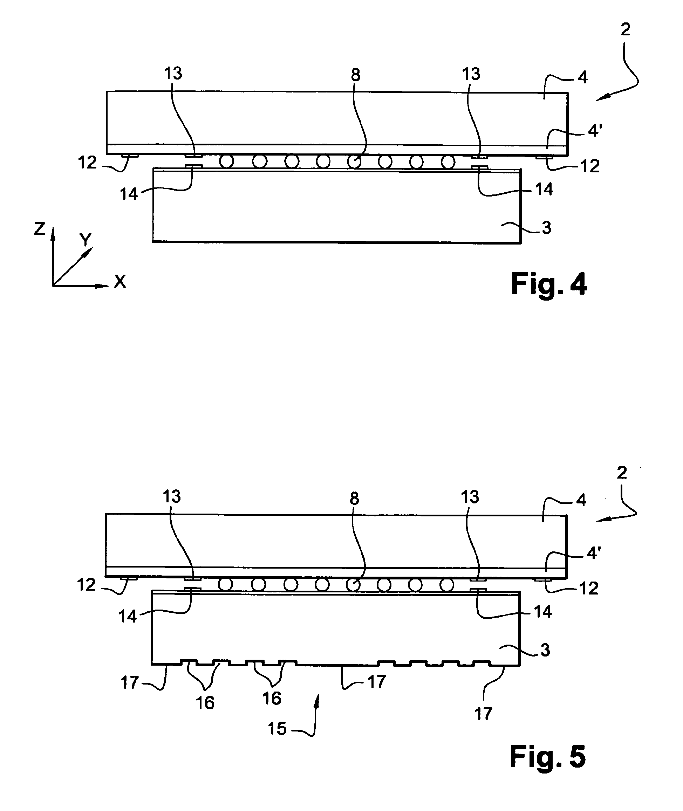

On procède ensuite (figure 5), à la mise en oeuvre de l'une des étapes du procédé de l'invention, consistant à rainurer la face arrière du circuit de lecture **3.** Ce rainurage définit des sillons **16** destinés à permettre la migration de la colle, notamment par capillarité, nécessaire au maintien du module élémentaire sur le substrat d'interconnexion **1.**

Ce rainurage est par exemple réalisé par sciage, ou gravure laser. La taille et le pas de ces sillons sont adaptés et déterminés de manière élémentaire par l'homme du métier au produit retenu pour assurer le maintien du module élémentaire sur le substrat d'interconnexion. Parallèlement, et ainsi qu'on peut l'observer sur la figure 5, des zones **17** de ladite face arrière **15** du circuit de lecture **3** sont exemptes de tels rainurages. Ces zones **17** sont destinées, ainsi que décrit ci-après, à entrer en contact direct avec le substrat d'interconnexion **1** et servir en outre de zone d'aspiration propre à maintenir le module élémentaire selon un positionnement précis, en particulier lors de l'étape de polymérisation de la colle circulant dans lesdites rainures ou sillons **16.**

Le substrat, également dénommé réseau d'interconnexion **1,** présente avantageusement un coefficient de dilatation thermique sur la plage de températures 80K-400/450K, très proche de celui du germanium, constitutif du substrat de contrainte collé au silicium aminci **3'.** Il est même très opportun de choisir un substrat d'interconnexion en germanium. En effet, outre le fait qu'on n'observe pas d'effet bilame entre le circuit de lecture et le substrat d'interconnexion, la mise en oeuvre de germanium est compatible avec les traitements sur les chaînes de fonderie silicium, en particulier pour les dépôt métalliques et les opérations de photolithographie nécessaire à l'obtention des motifs d'indexation. Il est rappelé que 80K est la température de fonctionnement du détecteur et 400K la température utilisable pour le collage.

De manière connue, le substrat d'interconnexion est destiné à assurer deux fonctions essentielles :
- permettre le positionnement des modules élémentaires **2** avec précision, selon le plan X,Y ;
- permettre le maintien desdits modules élémentaires déposés avec précision lors de leur solidarisation audit substrat.

En raison de l'interaction directe des zones **17** de la face arrière **15** du circuit de lecture **3** avec la face supérieure du substrat **1,** celui-ci doit présenter une très bonne planéité, notamment en face avant. En effet, les défauts de planéité de la face avant influent directement sur la dispersion selon la cote Z des photodiodes constituant le plan focal.

Selon une caractéristique de l'invention, ce substrat d'interconnexion comporte sur sa face avant également des motifs d'alignement **18,** positionnés à l'aplomb des motifs d'alignement **12** rapportés sur la face avant des circuits de détection, ainsi que décrit ci-après, ou sur un composant inactif sur le plan de la détection, hybridé sur le circuit de lecture.

C'est en fait le positionnement précis de ces motifs d'alignement **18** sur le substrat d'indexation qui va permettre le positionnement précis des modules élémentaires **2,** là encore à l'aide d'une machine type SUSS MICROTEC FC 150.

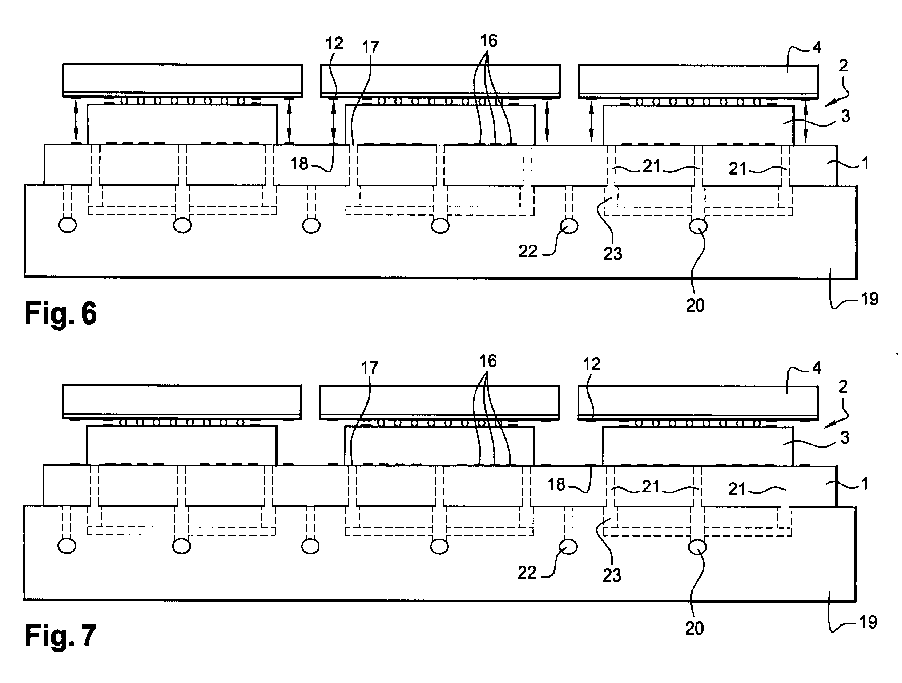

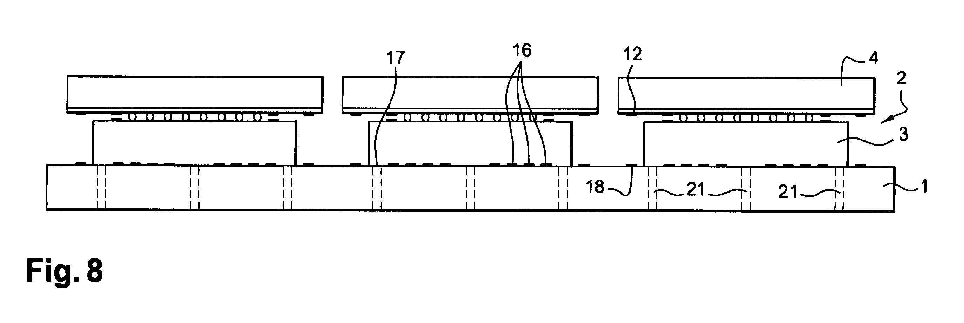

Parallèlement, le substrat d'interconnexion **1** est percé de part en part d'un certain nombre de canalisations **21,** débouchant au niveau de canalisations **23,** reliées à une source de vide ou à une source d'aspiration séquencée, associées à un outillage spécifique **19** conforme à l'invention. Ainsi qu'on peut bien l'observer au niveau des figures 7 à 9, les canalisations **21,** réalisées au sein du substrat d'interconnexion **1,** débouchent au niveau de la face avant dudit substrat à l'aplomb des zones **17** de la face arrière **15** des modules élémentaires exemptes de rainure.

Enfin, afin d'assurer un maintien efficace du substrat d'interconnexion sur l'outillage d'aspiration **19** précité, ledit outillage comporte également des sources d'aspiration **22,** débouchant au niveau de la face arrière du substrat d'interconnexion maintenant celui-ci plaqué contre ledit outillage lors des phases de positionnement des modules élémentaires et de polymérisation décrites ci-après.

Il va être décrit succinctement le procédé de fabrication d'une matrice à grand plan focal conforme à l'invention.

Après hybridation du ou des circuit(s) de détection **4, 5** sur le circuit de lecture **3** et réalisation des modules élémentaires **2,** on procède à un tri éléctro-optique des composants ainsi réalisés. Ce tri permet d'isoler parmi les modules élémentaires, ceux dont les performances électro-optiques sont compatibles avec les exigences requises du produit final.

On procède ensuite au rainurage de la face arrière du circuit de lecture **3** de chacun de ces modules élémentaires.

Corollairement, est réalisé le substrat d'interconnexion avec notamment perçage des canalisations **21** et positionnement précis des motifs d'alignement **18** en face avant. Au sein d'un four d'hybridation d'un type en soi connu, on positionne l'outillage **19** destiné à assurer une aspiration séquencée, au fur et à mesure du positionnement des modules élémentaires. On positionne sur cet outillage le substrat d'interconnexion **1,** maintenu sur celui-ci par activation de la source d'aspiration **22** plaquant le substrat **1** sur l'outillage **19.**

On procède alors au traitement d'un premier module élémentaire **2** en réalisant l'alignement des motifs d'alignement respectivement **12** dudit module sur les motifs d'alignement **18** du substrat d'interconnexion. Cet alignement est obtenu par juxtaposition des motifs **12** et **18** en utilisant pour cela la machine d'hybridation précitée. On procède de façon identique lors de la fabrication des modules élémentaires (motifs **13** et **14).** Il s'agit de l'une des fonctions de base d'un équipement d'hybridation.

Une fois cet alignement réalisé, on procède au dépôt effectif dudit module élémentaire sur le réseau ou substrat d'interconnexion avec commutation sous vide ou sous aspiration de la source d'aspiration **20** correspondante. Le premier module ainsi déposé est donc maintenu plaqué selon la position définie par cette mise sous vide ou cette aspiration, et l'on peut procéder ainsi au fur et à mesure au dépôt successif des n module(s) élémentaire(s) suivants, mettant en oeuvre n voie(s) d'aspiration **20.**

Une fois l'intégralité des modules élémentaires **2** ainsi positionnés et plaqués sur le substrat d'interconnexion **1,** on procède à un apport de colle époxy au niveau des différents rainurages **16,** jusqu'à complète migration de la colle par capillarité dans les sillons ainsi définis.

Le cycle de polymérisation est alors lancé en utilisant le four d'hybridation précité. Ce cycle peut cependant être incomplet car fonction limité au blocage de la structure pour éviter ainsi tout mouvement des modules élémentaires lors de la récupération du plan focal. Il s'agit dans le langage du métier d'une pré polymérisation ou polymérisation incomplète, dont le but est d'assurer le blocage de la structure reportée sans que la colle présente les propriétés mécaniques conférée par une polymérisation complète. Le cycle complet peut cependant être lancé sur le four d'hybridation.

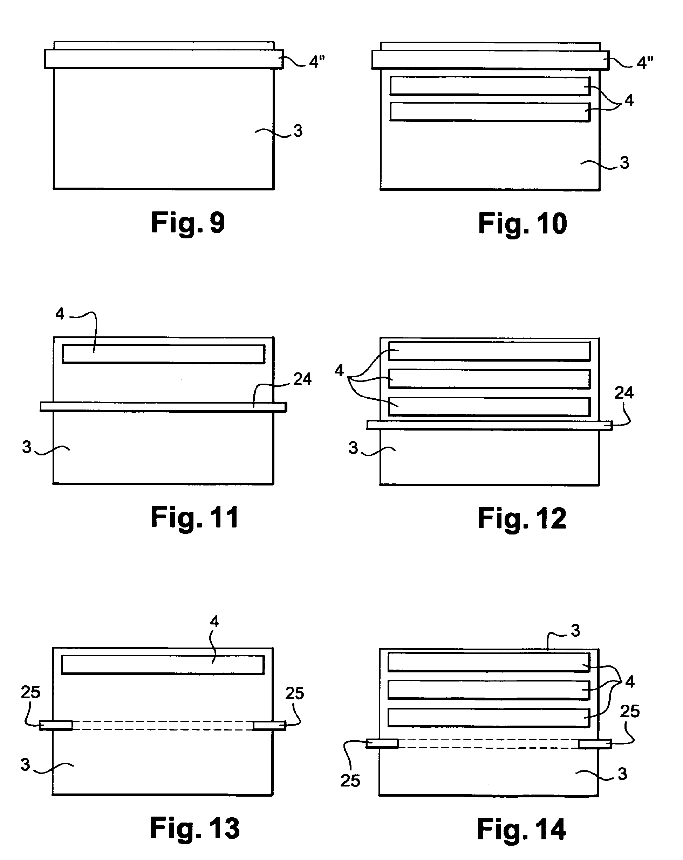

Les sources de vide ou d'aspiration **20** sont alors coupées. On peut alors retirer du four d'hybridation la matrice ainsi réalisée, tel que schématiquement représenté sur la figure 9 et l'on procède à un éventuel achèvement du cycle de polymérisation, avec le cas échéant un apport complémentaire de colle, dans des équipements conventionnellement utilisés (étuve par exemple).

Selon un premier mode de réalisation, le procédé ainsi décrit impose une contrainte dimensionnelle préalable sur la géométrie du circuit de détection. Plus exactement, cette exigence porte sur un seul des différents circuits de détection susceptibles d'être couplés ou hybridés à un même circuit de lecture.

Ainsi qu'on l'a représenté schématiquement sur les figures 9 et 10, on observe que la longueur d'au moins l'un **4"** des circuits de détection est supérieure à celle du circuit de lecture **3** sur lequel il est destiné à être hybridé.

En effet, il convient de pouvoir rapporter sur la face avant du circuit de détection particulier **4"** les motifs d'alignement **12,** permettant en cours du procédé de l'invention l'alignement du module de détection sur le substrat d'interconnexion.

Selon un autre mode de réalisation de l'invention, il est possible de s'affranchir de cette contrainte sur le circuit de détection, en mettant en oeuvre un composant **24,** dont la fonction demeure purement mécanique, à savoir le transfert des motifs d'alignement. De tels composants peuvent être provisoirement hybridés sur le circuit de lecture et sont ensuite déshybridés en fin de process (voir figures 11 et 12, et 13 et 14).

En effet, le dépassement par rapport au circuit de lecture, d'une partie de la structure active de l'élément de détection, présente toujours un risque lors des manipulations, montage , ...etc. Il est préférable que cette fonction de transfert d'alignement soit assurée par une pièce purement mécanique.

En outre, il peut s'avérer souhaitable, pour certaines applications, d'avoir à retirer le substrat support de l'élément de détection **(4** sur figure 4). Ce retrait nécessite généralement un enrobage préalable (par colle époxy) de la zone de connectique située entre le circuit de détection et le circuit de lecture **(4+4'** et **3** sur figure 4) afin d'assurer une bonne tenue mécanique de la partie active très fine **4'** par liaison rigide avec le circuit de lecture. L'enrobage de cette zone suppose que la dimension du circuit de détection soit inférieure à celle du circuit de lecture et donc que le transfert d'indexation soit assuré par une pièce non active.

On conçoit tout l'intérêt du procédé de l'invention qui permet ainsi de répondre aux contraintes de précision imposées par les systèmes selon les trois cotes X, Y et Z, puisqu'il n'y a plus d'interaction de film de colle séparant les modules élémentaires du substrat. La colle mise en oeuvre assure certes une fonction de solidarisation mais, ainsi qu'on l'aura compris, les modules reposent directement sur la face avant dudit substrat d'interconnexion au niveau des zones exemptes de rainures. On assure ainsi un parfait parallélisme entre ces faces d'appui, et par voie de conséquence, une excellente planéité du plan focal ainsi réalisé.

Parallèlement, le procédé met en oeuvre les machines d'hybridation et d'alignement déjà connues et maîtrisées par l'homme du métier.

Ce faisant, il devient possible de réalisation des matrices de détection à grand plan focal, de manière efficace, sans affecter la qualité et la précision de détection.

## Revendications

1. Procédé pour la réalisation d'une matrice de détection de rayonnements électromagnétiques, et notamment de rayons infrarouges, ladite matrice étant constituée d'une pluralité de modules de détection élémentaires **2** rapportés sur un substrat d'interconnexion **1,** et lesdits modules **2** étant eux-mêmes composés d'au moins un circuit de détection **4** dudit rayonnement, connecté à un circuit de lecture **3** par hybridation, lesdits circuits de lecture étant eux-mêmes solidarisés au substrat d'interconnexion **1, *caractérisé* en ce qu'**il consiste :
■ à ménager au niveau de la face arrière **15** du circuit de lecture **3** de chacun des modules élémentaires **2 :**
• des sillons ou rainures **16,** destinés à permettre la migration d'une colle apte à assurer la solidarisation desdits modules sur le substrat d'interconnexion **1,**
• et des zones **17** exemptes de tels sillons ou rainures, afin de permettre un contact direct entre lesdits modules et ledit substrat d'interconnexion ;
■ à rapporter d'une part, sur la face avant du substrat d'interconnexion **1,** et d'autre part sur la face avant du circuit de détection, des motifs d'indexation **18, 12,** aptes à assurer un positionnement précis, notamment selon les cotes X et Y de chacun des modules élémentaires **2** sur ledit substrat d'interconnexion **1 ;**
■ à induire le plaquage de chacun des modules élémentaires **2** sur le substrat d'interconnexion **1** après positionnement desdits modules, les zones **17** exemptes de sillons ou rainures **16** de la face arrière du circuit de lecture **3** étant alors en contact direct avec le substrat d'interconnexion **1 ;**
■ à procéder après ce plaquage à un appat decolle au niveau des sillons ou rainures 16 jusqu'à complète migration de la colle dans les sillons ou rainures **16** prévus à cet effet ;
■ à augmenter la température de l'enceinte de réalisation de ladite matrice pour induire la polymérisation de la colle.

2. Procédé pour la réalisation d'une matrice de détection de rayonnements électromagnétiques selon la revendication 1, ***caractérisé* en ce que** le plaquage des modules élémentaires sur le substrat d'interconnexion est obtenu par dépression ou aspiration desdits modules, le substrat étant percé de canalisations **23** reliées à une ou plusieurs sources de vide ou d'aspiration **20,** lesdites canalisations débouchant au niveau de la face avant du substrat d'interconnexion **1** à l'aplomb des zones **17** de la face arrière des modules élémentaires **2** exemptes de sillons ou de rainures.

3. Procédé pour la réalisation d'une matrice de détection de rayonnements électromagnétiques selon l'une des revendications 1 et 2, ***caractérisé* en ce que** la réalisation des modules élémentaires **2** et notamment l'alignement du ou des circuits de détection **4, 4", 5** sur un même circuit de lecture **3** est réalisé à l'aide de motifs d'indexation 14, 13 respectivement positionnés sur la face avant du circuit de lecture et sur la face arrière du ou des circuit(s) de détection.

4. Procédé pour la réalisation d'une matrice de détection de rayonnements électromagnétiques selon l'une des revendications 1 à 3, ***caractérisé* en ce que** l'un **4"** au moins des circuits de détection **4** d'un même module élémentaire présente une longueur telle qu'il dépasse de part et d'autre dudit module, afin de permettre la réalisation sur sa face arrière d'un motif d'indexation **12** permettant son positionnement précis sur le substrat d'interconnection 1 pourvu également de motifs d'indexation **18.**

5. Procédé pour la réalisation d'une matrice de détection de rayonnements électromagnétiques selon l'une des revendications 1 à 3, ***caractérisé* en ce que** l'on rapporte sur le circuit de lecture **3** un composant **24, 25,** dont la longueur dépasse également de part et d'autre du circuit de lecture, et destiné à recevoir un motif d'indexation **12,** ce composant étant hybridé provisoirement sur le circuit de lecture.

## Claims

1. A method for producing an array for detecting electromagnetic radiation, especially infrared radiation, said array consisting of a plurality of elementary detection modules **2** mounted on an interconnecting substrate **1** and said modules **2** themselves comprising at least one circuit **4** for detecting said radiation, connected to a read circuit **3** by hybridization, said read circuits themselves being attached to the interconnecting substrate **1, characterized in that** it consists :
■ in making, on the rear face **15** of the read circuit **3** of each of the elementary modules **2:**
• grooves or slots **16** designed to allow migration of an adhesive capable of ensuring attachment of said modules on the interconnecting substrate **1,**
• and areas **17** without such grooves or slots in order to allow direct contact between said modules and said interconnecting substrate;
■ in mounting, firstly on the front face of the interconnecting substrate **1,** and secondly on the front face of the detection circuit, registration features **18, 12** capable of ensuring accurate positioning, especially on the X and Y axes of each of the elementary modules **2** on said interconnecting substrate **1;**
■ in bringing about pressing of each of the elementary modules **2** onto the interconnecting substrate **1** after positioning of said modules, areas **17** which have no grooves or slots **16** on the rear face of the read circuit **3** then being in direct contact with the interconnecting substrate **1;**
■ in providing, after said bringing about pressing, an adhesive in the grooves or slots **16** until complete migration of said adhesive through grooves or slots **16** provided for this purpose;
■ in raising the temperature of the chamber used to produce said array in order to cause curing of the adhesive.

2. The method for producing an array for detecting electromagnetic radiation as claimed in claim 1, **characterized in that** the elementary modules are kept pressed against the interconnecting substrate by applying negative pressure or suction to said modules, the substrate being pierced by pipes **23** connected to one or more vacuum or suction sources **20,** said pipes emerge on the front face of interconnect substrate **1** in line with areas **17** of the rear face of elementary modules **2** which have no grooves or slots.

3. The method for producing an array for detecting electromagnetic radiation as claimed in any of the claims 1 and 2, **characterized in that** production of elementary modules **2,** in particular, alignment of detection circuit(s) **4, 4",** 5 on a single read circuit **3** is obtained by using registration features **14, 13** positioned respectively on the front face of the read circuit and on the rear face of the detection circuit(s).

4. The method for producing an array for detecting electromagnetic radiation as claimed in any of claims 1 to 3, **characterized in that** at least one **(4")** of the detection circuits **4** of a single elementary module has a length such that it projects either side of the said module in order to make it possible to produce, on its rear face, registration feature **12** allowing it to be positioned accurately on the interconnecting substrate which is also provided with registration features **18.**

5. The method for producing an array for detecting electromagnetic radiation as claimed in any of claims 1 to 3, **characterized in that** one mounts, on the read circuit **3,** a component **24, 25,** the length of which also projects either side of the read circuit and which is intended to receive registration feature **12,** this component being temporarily hybridized on the read circuit.

## Patentansprüche

1. Verfahren zur Herstellung einer Erfassungsmatrix für elektromagnetische Strahlungen, und insbesondere Infrarotstrahlen, wobei die Matrix aus mehreren Erfassungsgrundmodulen (2) gebildet ist, die auf einem Verbindungssubstrat (1) angebracht sind, und wobei die Module (2) selbst aus mindestens einer Erfassungsschaltung (4) für die Strahlung bestehen, die an eine Hybridisierungsleseschaltung (3) angeschlossen ist, wobei die Leseschaltungen selbst mit dem Verbindungssubstrat (1) fest verbunden sind, **dadurch gekennzeichnet, dass** es darin besteht:
■ im Bereich der Rückseite (15) der Leseschaltung (3) jedes der Grundmodule (2) Folgendes auszubilden:
• Rillen oder Kehlen (16), die dazu bestimmt sind, das Verlaufen eines Klebers zuzulassen, der in der Lage ist, die Befestigung der Module auf dem Verbindungssubstrat (1) sicherzustellen,
• und Bereiche (17), die frei von derartigen Rillen oder Kehlen sind, um einen direkten Kontakt zwischen den Modulen und dem Verbindungssubstrat zuzulassen;
■ einerseits auf der Vorderseite des Verbindungssubstrats (1) und andererseits auf der Vorderseite der Erfassungsschaltung Indexierungsmarkierungen (18, 12) anzubringen, die in der Lage sind, eine genaue Positionierung jedes der Grundmodule (2) am Verbindungssubstrat (1) insbesondere entlang deren Seiten X und Y sicherzustellen;
■ das Andrücken jedes der Grundmodule (2) am Verbindungssubstrat (1) nach Positionierung der Module herbeizuführen, wobei die von Rillen oder Kehlen (16) freien Bereiche (17) der Rückseite der Leseschaltung (3) dann in direktem Kontakt mit dem Verbindungssubstrat (1) sind;
■ nach diesem Andrücken ein Auftragen von Kleber im Bereich der Rillen oder Kehlen (16) bis zum vollständigen Verlaufen des Klebers in den zu diesem Zweck vorgesehenen Rillen oder Kehlen (16) vorzunehmen;
■ die Temperatur in dem Herstellungsraum für die Matrix zu erhöhen, um die Polymerisierung des Klebers zu induzieren.

2. Verfahren nach Anspruch 1 zur Herstellung einer Erfassungsmatrix für elektromagnetische Strahlungen, **dadurch gekennzeichnet, dass** das Andrücken der Grundmodule an das Verbindungssubstrat durch Unterdruck oder Ansaugen der Module erreicht wird, wobei das Substrat mit Kanälen (23) durchzogen ist, die mit einer oder mehreren Vakuum- oder Ansaugquelle/n (20) verbunden sind, wobei die Kanäle im Bereich der Vorderseite des Verbindungssubstrats (1) lotrecht zu den Bereichen (17) der Rückseite der Grundmodule (2) münden, die frei von Rillen oder Kehlen sind.

3. Verfahren nach einem der Ansprüche 1 und 2 zur Herstellung einer Erfassungsmatrix für elektromagnetische Strahlungen, **dadurch gekennzeichnet, dass** die Herstellung der Grundmodule (2) und insbesondere die Ausrichtung der Erfassungsschaltung/en (4, 4", 5) auf ein und derselben Leseschaltung (3) mittels Indexierungsmarkierungen (14, 13) erfolgt, die sich jeweils auf der Vorderseite der Leseschaltung und auf der Rückseite der Erfassungsschaltung/en befinden.

4. Verfahren nach einem der Ansprüche 1 bis 3 zur Herstellung einer Erfassungsmatrix für elektromagnetische Strahlungen, **dadurch gekennzeichnet, dass** mindestens die eine (4") der Erfassungsschaltungen (4) ein und desselben Grundmoduls eine solche Länge aufweist, dass sie beidseits des Moduls vorsteht, um die Herstellung einer Indexierungsmarkierung (12) auf ihrer Rückseite zuzulassen, das ihre genaue Positionierung auf dem Verbindungssubstrat (1) zulässt, das ebenfalls mit Indexierungsmarkierungen (18) versehen ist.

5. Verfahren nach einem der Ansprüche 1 bis 3 zur Herstellung einer Erfassungsmatrix für elektromagnetische Strahlungen, **dadurch gekennzeichnet, dass** auf der Leseschaltung (3) ein Bauteil (24, 25) angebracht wird, dessen Länge ebenfalls beidseits der Leseschaltung vorsteht, und das dazu bestimmt ist, eine Indexierungsmarkierung (12) aufzunehmen, wobei dieses Bauteil provisorisch auf die Leseschaltung hybridisiert ist.
